(19) Europäisches Patentamt
European Patent Office
Office européen des brevets

(11) **EP 1 187 312 B1**

(12) **EUROPÄISCHE PATENTSCHRIFT**

(45) Veröffentlichungstag und Bekanntmachung des Hinweises auf die Patenterteilung:
**07.03.2007 Patentblatt 2007/10**

(51) Int Cl.:
*H03F 3/00* (2006.01)     *H03K 5/15* (2006.01)
*H03K 5/13* (2006.01)

(21) Anmeldenummer: **01118996.6**

(22) Anmeldetag: **06.08.2001**

(54) **Variables Taktschema für Switched-Opamp-Schaltungen**

Variable clock scheme for switched opamp circuits

Schéma d'horloge variable pour amplificateurs opérationnels commutés

(84) Benannte Vertragsstaaten:
**DE FR GB**

(30) Priorität: **18.08.2000 DE 10040422**

(43) Veröffentlichungstag der Anmeldung:
**13.03.2002 Patentblatt 2002/11**

(73) Patentinhaber: **Infineon Technologies AG**
**81669 München (DE)**

(72) Erfinder:
• **Sauerbrey, Jens**
**82024 Taufkirchen (DE)**
• **Wittig, Martin**
**27751 Delmenhorst (DE)**
• **Thewes, Roland**
**82194 Gröbenzell (DE)**

(74) Vertreter: **Lange, Thomas et al**
**Patentanwälte**
**Lambsdorff & Lange**
**Dingolfinger Strasse 6**
**81673 München (DE)**

(56) Entgegenhaltungen:
EP-A- 0 689 286         EP-A- 0 836 275
WO-A-96/25795          US-A- 5 818 276
US-A- 5 880 619         US-A- 6 081 218

• **PATENT ABSTRACTS OF JAPAN Bd. 009, Nr. 212 (E-339), 29. August 1985 (1985-08-29) & JP 60 074815 A (NIPPON DENKI KK;OTHERS: 01), 27. April 1985 (1985-04-27)**

**Beschreibung**

Die Erfindung betrifft eine Schaltungsanordnung in Switched-Opamp-Technik, sowie ein Verfahren zur Taktung aufeinanderfolgender, in Switched-Opamp-Technik ausgeführter Operationsverstärker-Stufen.

Die Switched-Opamp-Technik hat sich aus der Switched-Capacitor-Technik entwickelt, um dem Bedürfnis nach immer niedrigeren Versorgungsspannungen Rechnung tragen zu können. Die Switched-Opamp-Technik kommt beim Bau von Filtern und Wandlern zur Anwendung und eignet sich insbesondere für Anwendungsgebiete, in denen es auf geringe Leistungsaufnahme ankommt. Dazu gehören beispielsweise Anwendungen im Mobilfunkbereich, bei denen die Beanspruchung des Akkus möglichst gering gehalten werden muß.

Während bei der Switched-Capacitor-Technik die Kapazitäten durch getaktete Schalter ein- und ausgeschaltet werden, werden bei der Switched-Opamp-Technik zusätzlich auch die Operationsverstärker durch ein Schalttaktsignal ein- und ausgeschaltet. Dadurch wird eine erhebliche Leistungseinsparung erzielt.

Stand der Technik ist es, zwei aufeinanderfolgende Operationsverstärker-Stufen mit entgegengesetztem Takt zu betreiben. Zur Taktung wird ein bekannter nichtüberlappender Zwei-Phasentakt verwendet. Aus diesem Grund sind die Operationsverstärker der aufeinanderfolgenden Stufen nie gleichzeitig aktiv. Das Taktschema wird jedoch so gewählt, daß jeder Operationsverstärker zu annähernd 50% eingeschaltet ist.

EP Ø689286 offenbart eine Schaltung in Switched-Opamp-Technik welches von einem nicht überlappenden Zweiphasentakt angesteuert wird.

Der Erfindung liegt die Aufgabe zugrunde, eine Schaltungsanordnung in Switched-Opamp-Technik sowie ein Verfahren zur Taktung aufeinanderfolgender, in Switched-Opamp-Technik ausgeführter Operationsverstärker-Stufen zu schaffen, welche eine weitere Verringerung der Leistungsaufnahme von Switched-Opamp-Schaltungen ermöglicht.

Diese Aufgabe wird durch eine Schaltungsanordnung gemäß Anspruch 1 sowie durch ein Verfahren zur Taktung aufeinanderfolgender Operationsverstärker-Stufen gemäß Anspruch 16 gelöst.

Die erfindungsgemäße Schaltungsanordnung in Switched-Opamp-Technik weist mindestens einen schaltbaren Operationsverstärker, mindestens einen mit dem Eingang des Operationsverstärkers verbindbaren Sampling-Kondensator, sowie mindestens einen zwischen dem Eingang und dem Ausgang des Operationsverstärkers angeordneten Integrationskondensator auf.

Zur Steuerung der Schaltungsanordnung werden mindestens zwei nichtüberlappende Schalttaktsignale erzeugt. Solange das eine der beiden Schalttaktsignale auf 1 ist, wird der Sampling-Kondensator durch das Eingangssignal aufgeladen. Während dieser Phase ist das andere der beiden Schalttaktsignale auf 0, und der Operationsverstärker befindet sich im ausgeschalteten Zustand. Nach Beendigung dieser Sampling-Phase befinden sich sämtliche Schalttaktsignale in einer gemeinsamen Aus-Phase. Anschließend geht das andere der beiden Schalttaktsignale auf 1 über und schaltet so den Operationsverstärker ein. Während der nun einsetzenden Integrationsphase überträgt der Operationsverstärker als aktives Bauelement die Ladung des mit seinem Eingang verbundenen Sampling-Kondensators auf den Integrationskondensator. Nach dem Ende der Integrationsphase befinden sich wieder beide Schalttaktsignale auf 0.

Die erfindungsgemäße Schaltungsanordnung weist Mittel zur Variation der Schalttaktphasen auf, in denen sich sämtliche Schalttaktsignale in der Aus-Phase befinden. Dadurch können die Schalttaktphasen, in denen sich beide Schalttaktsignale auf 0 befinden, auf Kosten der Einschaltphasen ausgedehnt werden. Es muß lediglich gewährleistet sein, daß während der Einschaltphase des einen Schalttaktsignals die vollständige Aufladung des Sampling-Kondensators durch das Eingangssignal erfolgen kann, und daß während der Einschaltphase des anderen Schalttaktsignals der Operationsverstärker so einschwingen kann, daß die Ladung auf den Integrationskondensator übertragen wird.

Die gemeinsame Aus-Phase der beiden Schalttaktsignale kann somit bis zu der durch das Einschwingverhalten vorgegebenen Grenze verlängert werden. Damit kann das Potential zur Leistungseinsparung voll ausgeschöpft werden. Insofern eignet sich die Erfindung insbesondere für den Einsatz in Mobilfunkgeräten (Handys), mobilen Internet-Geräten (WAP-Technologie), aber auch für medizinische Einsatzzwecke (Hörgeräte, Herzschrittmacher, etc.), bei denen es auf eine hohe Lebensdauer der verwendeten Batterien ankommt.

Insbesondere ist es mit der Erfindung möglich, die Länge der Ein- und Ausschaltphasen individuell an die Güte der verwendeten Operationsverstärker anzupassen. Um den Einfluß von Prozeß-Streuungen bei der Herstellung zu berücksichtigen, müssen analoge Schaltungen so dimensioniert werden, daß sie auch bei ungünstigen Prozeßauswirkungen noch die geforderte Spezifikation erfüllen. In vielen Fällen ist daher das Verhalten einer analogen Schaltung besser als vom Hersteller angegeben. Wenn das Einschwingverhalten des eingesetzten Operationsverstärkers besser ist als angegeben, dann kann dieses Potential zur Leistungseinsparung mit der vorliegenden Erfindung ausgeschöpft werden.

Dabei ist es von Vorteil, wenn jede der Schalttaktphasen, in denen sich sämtliche Schalttaktsignale in der Aus-Phase befinden, variierbar ist. Sowohl die gemeinsame Aus-Phase, die auf die Einschaltphase des ersten Schalttaktsignals folgt, als auch die gemeinsame Aus-Phase, die auf die Einschaltphase des zweiten Schalttaktsignals folgt, werden verlängert. Dadurch entsteht ein gleichmäßiges Schaltschema. Es ist aber auch möglich, die auf die Einschaltphase des ersten Schalttaktsignals folgende und die auf die Einschaltphase des zweiten Schalttaktsignals folgende Aus-Phase verschieden lang zu gestalten.

Alternativ dazu ist es möglich, nur jede zweite der Schalttaktphasen, in denen sich sämtliche Schalttaktsignale in der Aus-Phase befinden, zu variieren. Bei dieser Lösung wird jeweils nur die auf die Einschaltphase des ersten Schalttaktsignals folgende Aus-Phase verlängert, oder aber es wird jeweils nur die auf die Einschaltphase des zweiten Schalttaktsignals folgende Aus-Phase verlängert. Es wird also jeweils jede zweite gemeinsame Aus-Phase verlängert.

Es ist von Vorteil, wenn die Dauer der Schalttaktphasen, in denen sich sämtliche Schalttaktsignale in der Aus-Phase befinden, in Abhängigkeit vom Einschwingverhalten des Operationsverstärkers variierbar ist. Um die maximale Leistungseinsparung zu erzielen, muß die Einschaltphase gerade so lang gewählt werden, daß der Operationsverstärker einschwingen kann. Nach Beendigung des Einschwingvorgangs kann der Operationsverstärker abgeschaltet werden.

Gemäß einer weiteren vorteilhaften Ausführungsform der Erfindung ist die Dauer der Schalttaktphasen, in denen sich sämtliche Schalttaktsignale in der Aus-Phase befinden, in Abhängigkeit von der Schaltgeschwindigkeit der Transistoren variierbar. Da ein Operationsverstärker aus Einzeltransistoren aufgebaut ist, wird das Einschwingverhalten des Operationsverstärkers im wesentlichen durch die Schaltgeschwindigkeit der Transistoren bestimmt. Daher handelt es sich bei der Transistor-Schaltgeschwindigkeit um ein leicht erfaßbares Maß für das Einschwingverhalten des Operationsverstärkers. Die Schaltgeschwindigkeit der Transistoren kann direkt zur Bestimmung der Dauer der gemeinsamen Aus-Phasen herangezogen werden: Je schneller die Transistoren schalten, desto länger kann die gemeinsame Aus-Phase gewählt werden, und desto höher ist die Leistungsersparnis.

Es ist von Vorteil, wenn die Schaltungsanordnung Mittel zur Erfassung der Transistor-Schaltgeschwindigkeit umfaßt. Auf diese Weise kann die Transistor-Schaltgeschwindigkeit auf dem Substrat individuell erfaßt werden, so daß die Länge der gemeinsamen Aus-Phasen auf die Güte des verwendeten Operationsverstärkers abgestimmt werden kann.

Dabei ist es von Vorteil, wenn die Schaltgeschwindigkeit von n-Kanal FETs und/oder von p-Kanal FETs separat erfaßbar ist. Der Prozeß für die Herstellung von n-FETs und von p-FETs umfaßt völlig unterschiedliche Prozeßschritte. Insofern ist es möglich, daß n-FETs und p-FETs, welche sich auf ein und demselben Substrat befinden, in Hinblick auf ihre Schaltgeschwindigkeiten erheblich differieren. In Abhängigkeit von der internen Beschaltung eines Operationsverstärkers kann dessen Einschwingverhalten hauptsächlich vom Verhalten der n-FETs oder der p-FETs geprägt sein. In diesem Fall empfiehlt es sich, die Schaltgeschwindigkeit des maßgeblichen Device-Typs separat zu erfassen.

Es ist von Vorteil, wenn die Mittel zur Erfassung der Transistor-Schaltgeschwindigkeit ein XOR-Gatter umfassen, an dessen Eingängen ein nicht verzögertes Flankensignal sowie ein über eine Inverterkette verzögertes Flankensignal anlegbar sind. Mit dieser einfachen Schaltung läßt sich die durch die Inverterkette bewirkte Signalverzögerung in einen Puls umsetzen, dessen Dauer exakt der durch die Inverterkette hervorgerufenen Signalverzögerung entspricht. Da die Inverterkette aus einzelnen FETs aufgebaut ist, kann mit dieser Schaltung die Transistor-Schaltgeschwindigkeit erfaßt werden. Insbesondere ist es möglich, die Inverterkette so aufzubauen, daß die Verzögerung entweder hauptsächlich durch n-FETs oder hauptsächlich durch p-FETs bewirkt wird. Daher kann mit dieser Schaltung die Schaltgeschwindigkeit von n-Kanal FETs und/oder von p-Kanal FETs auch separat erfaßt werden.

Ganz allgemein ist es von Vorteil, wenn die Mittel zur Erfassung der Transistor-Schaltgeschwindigkeit Pulse erzeugen, deren Dauer die Schaltgeschwindigkeit der Transistoren charakterisiert. Die Dauer derartiger Pulse läßt sich mit Hilfe von Zähler- und Timer-Bausteinen genau erfassen und kann als Grundlage für eine digitale Regelung verwendet werden.

Es ist von Vorteil, die Dauer der Schalttaktphasen, in denen sich sämtliche Schalttaktsignale in der Aus-Phase befinden, in Abhängigkeit von der Dauer der Meßschaltungs-Pulse einzustellen. Je schneller die Transistoren schalten, desto kürzer sind die am Ausgang der Meßschaltung auftretenden Pulse, und umso kürzer können die Einschaltphasen gewählt werden. Die gemeinsamen Aus-Phasen der Schalttaktsignale können dementsprechend verlängert werden.

Gemäß einer weiteren vorteilhaften Ausführungsform der Erfindung ist die Dauer der Schalttaktphasen, in denen sich sämtliche Schalttaktsignale in der Aus-Phase befinden, in mehreren vorgegebenen Stufen einstellbar. Dieser Ausführungsform liegt die Überlegung zugrunde, daß sich ein Großteil der Leistungseinsparung bereits mit einer relativ groben Einstellung der Dauer der Einschaltphasen sowie der gemeinsamen Aus-Phase realisieren läßt. Insofern ist es sinnvoll, die Dauer der Schalttaktphasen, in denen sich sämtliche Schalttaktsignale in der Aus-Phase befinden, nur stufenweise anzupassen. Dies kann mit geringem Schaltungsaufwand erreicht werden.

Vorzugsweise sind die Mittel zur Takterzeugung sowie die Mittel zur Variation der Schalttaktphasen, in denen sich sämtliche Schalttaktsignale in der Aus-Phase befinden, mittels eines programmierbaren Taktgenerators realisiert. In einem programmierbaren Taktgenerator werden die Längen der einzelnen Schalttaktphasen digital repräsentiert und mittels Zähler- und Timerschaltungen in entsprechende Schalttaktsignale umgesetzt. Die Dauer der einzelnen Schalttaktphasen kann auf einfache Weise umprogrammiert werden.

Alternativ dazu ist es von Vorteil, wenn die Mittel zur Takterzeugung sowie die Mittel zur Variation der Schalttaktphasen, in denen sich sämtliche Schalttaktsignale in der Aus-Phase befinden, mittels eines externen Rechteckgenerators und einer Teilerschaltung realisiert sind. Dabei erzeugt die Teilerschaltung aus dem Rechtecksignal die mindestens zwei Schalttaktsignale. Auf diese Weise kann mit geringem externen Schaltungsaufwand herausgefunden werden, wie groß bei einer bestimmten Filter- oder Wandlerschaltung die Streuung des Einschwingverhaltens ist bzw. ob noch Potential zur Leistungseinsparung vorhanden ist. Das Tastverhältnis des Rechtecksignals kann am externen Rechteckgenerator eingestellt werden. Mittels des Tastverhältnisses kann die gemeinsame Aus-Phase der Schalttaktsignale variiert werden.

Es ist von Vorteil, wenn die Schaltungsanordnung in volldifferentieller Schaltungstechnik realisiert ist. Insbesondere bei Anwendungen in der Mobilfunktechnik können durch differentielle Ausführung der Signalleitungen Störungen wirkungsvoll eliminiert werden.

Bei dem erfingungsgemäßen Verfahren zur Taktung aufeinanderfolgender, in Switched-Opamp-Technik ausgeführter Operationsverstärker-Stufen werden in einem ersten Schritt mindestens zwei nichtüberlappende Schalttaktsignale erzeugt, wobei das erste Schalttaktsignal einen ersten Operationsverstärker ein- und ausschaltet, und wobei das zweite Schalttaktsignal einen zweiten Operationsverstärker ein- und ausschaltet. In einem zweiten Schritt werden die Phasen der Schalttaktsignale, in denen sämtliche Operationsverstärker ausgeschaltet sind, variiert.

Durch die Einführung einer steuerbaren gemeinsamen Aus-Phase können die Einschaltzeiten der Operationsverstärker auf das notwendige Maß herabgesetzt werden, so daß die Leistungsaufnahme der Schaltung auf ein Minimum beschränkt werden kann.

Nachfolgend wird die Erfindung anhand mehrerer in der Zeichnung dargestellter Ausführungsbeispiele weiter beschrieben.

Es zeigen:

Fig. 1    eine typische, mehrere Operationsverstärker-Stufen umfassende Schaltung in Switched-Opamp-Technik;

Fig. 2A    eine Schaltung zur Erzeugung eines nichtüberlappenden Zwei-Phasentakts gemäß dem Stand der Technik;

Fig. 2B    eine Darstellung des Eingangstaktsignals sowie der von der Schaltung gemäß Fig. 2A erzeugten Even- und Odd-Schalttaktsignale;

Fig. 3    ein Blockschaltbild der erfindungsgemäßen Takterzeugungseinheit, die eine Schaltung zur Bestimmung der Transistor-Schaltgeschwindigkeit umfaßt;

Fig. 4    eine Schaltung zur Bestimmung der Gatterlaufzeit bzw. der Transistor-Schaltgeschwindigkeit für den Einsatz in der erfindungsgemäßen Takterzeugungseinheit;

Fig. 5A    eine Darstellung des Eingangstaktsignals sowie des Ausgangssignals der in Fig. 4 gezeigten Schaltung für den Fall kurzer Gatterlaufzeiten;

Fig. 5B    den zeitlichen Verlauf der von der erfindungsgemäßen Takterzeugungseinheit generierten Even- und Odd-Schalttaktsignale für den Fall kurzer Gatterlaufzeiten;

Fig. 6A    eine Darstellung des Eingangstaktsignals sowie des Ausgangssignals der in Fig. 4 gezeigten Schaltung für den Fall langer Gatterlaufzeiten;

Fig. 6B    den zeitlichen Verlauf der von der erfindungsgemäßen Takterzeugungeinheit generierten Even- und Odd-Schalttaktsignale für den Fall langer Gatterlaufzeiten;

Fig. 7    eine Schaltung, welche die separate Bestimmung der Schaltgeschwindigkeit von n-Kanal MOSFETs ermöglicht;

Fig. 8    eine Übersicht über die Taktsignale einer externen Takterzeugungungseinheit, bei der das Even- und das Odd-Taktsignal mittels einer Teilerschaltung aus einem Rechtecksignal erzeugt werden.

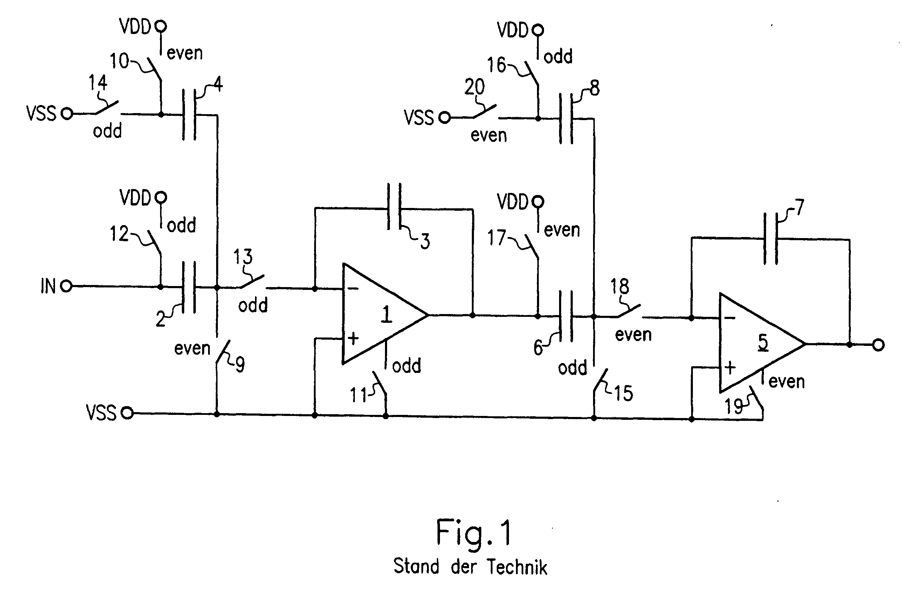

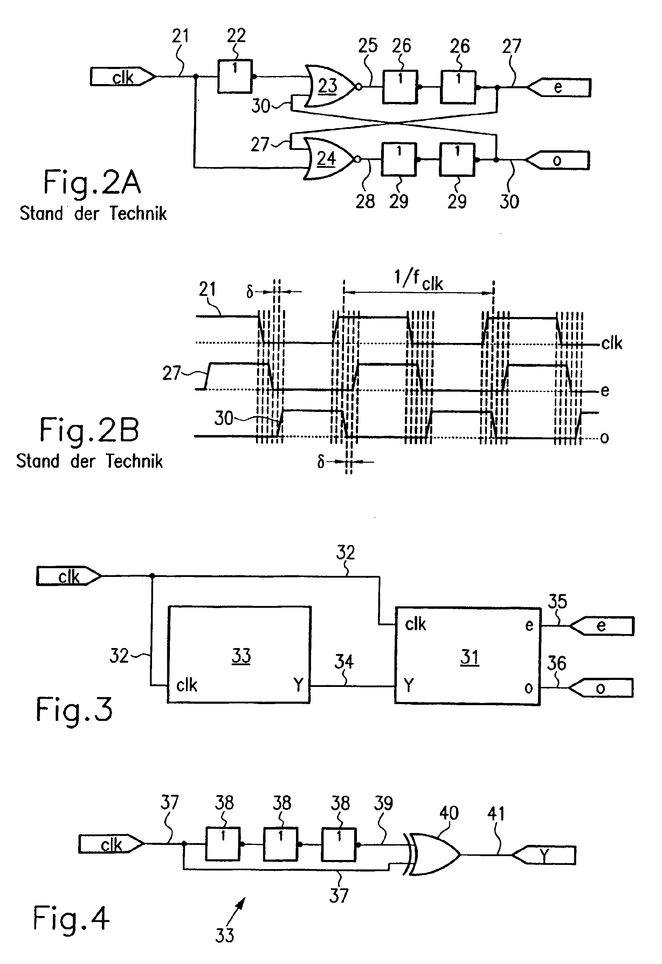

In Fig. 1 ist eine typische Switched-Opamp-Schaltung dargestellt, welche zwei Operationsverstärker-Stufen umfaßt. Die erste Operationsverstärker-Stufe wird durch den Operationsverstärker 1, den Sampling-Kondensator 2, den Integrationskondensator 3 sowie den Kondensator 4 gebildet. Die zweite Operationsverstärker-Stufe umfaßt den Operationsverstärker 5, den Sampling-Kondensator 6, den Integrationskondensator 7 sowie den Kondensator 8. Die verschiedenen in Fig. 1 dargestellten Schalter werden durch zwei nichtüberlappende Schalttaktsignale ein- und ausgeschaltet, die im folgenden als Even- und Odd-Schalttaktsignal bezeichnet werden. Bevor auf die Funktionsweise der in Fig. 1 gezeigten Schaltung näher eingegangen wird, soll die Erzeugung dieser beiden Schalttaktsignale anhand der Figuren 2A und 2B erläutert werden.

Fig. 2A zeigt einen Taktgenerator zur Erzeugung eines nichtüberlappenden Zwei-Phasentakts, wie aus dem Stand der Technik bekannt ist. Am Eingang der Schaltung wird ein rechteckförmiges Eingangstaktsignal 21 der Frequenz $f_{clk}$ angelegt. Der zeitliche Verlauf dieses Eingangstaktsignals 21 ist in Figur 2B dargestellt.

Das Eingangstaktsignal 21 liegt einerseits am Eingang des Inverters 22 und außerdem an einem Eingang des zweiten NOR-Gatters 24 an. Der Ausgang des Inverters 22 ist mit einem Eingang des ersten NOR-Gatters 23 verbunden. Am Ausgang des NOR-Gatters 23 liegt das Ausgangssignal 25 an, das durch die beiden Inverter 26 verzögert wird. Am Ausgang der Inverterkette kann das Even-Schalttaktsignal 27 abgegriffen werden, dessen zeitlicher Verlauf in Fig. 2B gezeigt ist. Das Even-Schalttaktsignal 27 ist mit dem zweiten Eingang des zweiten NOR-Gatters 24 verbunden, an dessen Ausgang das Ausgangssignal 28 erscheint. Das Ausgangssignal 28 wird durch die beiden Inverter 29 verzögert; am Ausgang der Inverterkette kann dann das Odd-Schalttaktsignal 30 abgegriffen werden, dessen zeitlicher Verlauf ebenfalls in Fig. 2B dargestellt ist. Dieses Odd-Schalttaktsignal 30 wird dem zweiten Eingang des ersten NOR-Gatters 23 zugeführt.

Beim Vergleich des Verlaufs des Even-Schalttaktsignals 27 und des Odd-Schalttaktsignals 30 anhand von Fig. 2B ergibt sich, daß sich das Odd-Schalttaktsignal 30 jeweils während der Einschaltphase des Even-Schalttaktsignals 27 ausgeschaltet ist. Darüber hinaus befinden sich zwischen der Einschaltphase des Even-Schalttaktsignals 27 und der Einschaltphase des Odd-Schalttaktsignals 30 während der Zeitdauer δ beide Schalttaktsignale in einer gemeinsamen Aus-Phase. Man spricht daher von einem "nichtüberlappenden Zwei-Phasentakt".

Jeder der in Fig. 1 gezeigten Schalter wird nun entweder durch das Even-Schalttaktsignal oder durch das Odd-Schalttaktsignal ein- und ausgeschaltet. Neben jedem Schalter ist vermerkt, durch welchen Schalttakt er getaktet wird.

Es soll nun zunächst die erste Operationsverstärker-Stufe während der Einschaltphase des Even-Schalttakts betrachtet werden. Die Schalter 9 und 10 sind daher geschlossen während die Schalter 11, 12, 13 und 14 geöffnet sind. Der Operationsverstärker 1 ist daher in dieser Phase inaktiv. Am einen Anschluß des Sampling-Kondensators 2 liegt das Eingangssignal IN an; der andere Anschluß ist mit VSS verbunden. Daher wird der Sampling-Kondensator 2 durch das Eingangsignal aufgeladen. Der Kondensator 4 ist über die Schalter 9 und 10 mit VSS und VDD verbunden und wird daher durch die Versorgunsspannung aufgeladen. An die Einschaltphase des Even-Schalttaktsignals schließt sich - nach einer kurzen gemeinsamen Aus-Phase beider Schalttaktsignale - die Einschaltphase des Odd-Schalttaktsignals an. Während dieser Phase sind die Schalter 9 und 10 geöffnet, während die Schalter 11, 12, 13 und 14 geschlossen sind. Der Operationsverstärker 1 ist daher in dieser Phase eingeschaltet. Der eine Anschluß des Sampling-Kondensators 2 ist über den Schalter 12 auf VDD gelegt. Der andere Anschluß dieses Kondensators liegt über den Schalter 13 am invertierenden Eingang des Operationsverstärkers 1 an. Durch den Kondensator 4, der in dieser Phase über den Schalter 14 mit VSS verbunden ist, wird zusätzlich eine konstante Ladung eingekoppelt, die eine Art Gleichspannungsverschiebung bewirkt. Durch diese eingekoppelte Ladung kann erreicht werden, daß der invertierende Eingang etwa auf dem Potential VSS liegt. Der Operationsverstärker 1 als aktives Bauelement versucht nun, seinen Ausgang so nachzuregeln, daß die Differenz der Eingangsspannungen 0 wird. Der Operationsverstärker 1 versucht daher, den invertierenden Eingang auf VSS-Potential zu bringen. Dies führt im Ergebnis dazu, daß genau die Ladungsmenge, die auf dem Sampling-Kondensator 2 gesampelt war, auf den Integrationskondensator 3 übertragen wird.

Die zweite Operationsverstärker-Stufe wird gegenphasig zur ersten betrieben. Es wird immer noch die Einschaltphase des Odd-Schalttakts betrachtet, in der der Operationsverstärker 1 aktiv ist. Die Schalter 15 und 16 der zweiten OP-Stufe sind geschlossen, und deshalb lädt der Ausgang des Operationsverstärkers 1 den zur zweiten Operationsverstärker-Stufe gehörigen Sampling-Kondensator 6 auf. Die Integrationsphase der ersten Operationsverstärker-Stufe und die Sampling-Phase der zweiten Operationsverstärker-Stufe finden also gleichzeitig statt.

In der sich anschließenden Schalttaktphase wird die auf den Sampling-Kondensator 6 gesampelte Ladungsmenge auf den Integrationskondensator 7 übertragen. Während dieser Integrationsphase der zweiten Operationsverstärker-Stufe befindet sich die erste Operationsverstärker-Stufe bereits wieder in der Sampling-Phase.

Das in Fig. 2B dargestellte Schalttaktschema wird durch die Erfindung so modifiziert, daß die Einschaltzeiten der Operationsverstärker verkürzt werden und somit eine Leistungseinsparung erzielt wird. Die erfindungsgemäße Hardware ist in Fig. 3 dargestellt. Ein programmierbarer Taktgenerator 31 wird mit einem rechteckförmigen Eingangstaktsignal 32 der Frequenz $f_{clk}$ versorgt. Eine Schaltung 33 zur Bestimmung der Transistor-Schaltgeschwindigkeit ermittelt die für das Einschwingverhalten der Operationsverstärker maßgebliche Schaltgeschwindigkeit der Transistoren. Ein für diese Schaltgeschwindigkeit charakteristisches Pulssignal 34 wird dem programmierbaren Taktgenerator 31 zugeführt und bei der Erzeugung des Even-Schalttaktsignals 35 sowie des Odd-Schalttaktsignals 36 berücksichtigt. Je schneller die Devices schalten, desto kürzer können die Einschaltphasen der Operationsverstärker sein.

Fig. 4 zeigt ein Beispiel für eine Schaltung 33 zur Bestimmung der Transistor-Schaltgeschwindigkeit. Das Eingangstaktsignal 37 liegt am ersten Eingang des XOR-Gatters 40 an. Am zweiten Eingang des XOR-Gatters 40 liegt das verzögerte und invertierte Taktsignal 39 an, das durch eine ungerade Zahl von Invertierungen (in Fig. 4 sind drei Inverter 38 gezeigt) aus dem Eingangstaktsignal 37 erhalten wird. Wenn sich das Eingangstaktsignal 37 auf 0 befindet, dann nimmt das Signal 39 den Wert 1 an, und das Ausgangssignal 41 des XOR-Gatters 40 nimmt den Wert 1 an. Wenn das Eingangstaktsignal 37 von 0 auf 1 übergeht, dann liegt der neue Wert 1 unmittelbar am ersten Eingang des XOR-Gatters 40 an. Das Signal 39 geht erst mit einer gewissen Zeitverzögerung, die durch die Gatterlaufzeit der drei Inverter 38 bestimmt wird, auf den neuen Wert 0 über. Während einer für die Gatterlaufzeit charakteristischen Zeitdauer ist das Ausgangssignal 41 daher auf 0, anschließend nimmt es den Wert 1 an.

Die Dauer der Pulse im Ausgangssignal 41 stellt ein Maß für die Schaltgeschwindigkeit der Transistoren des Substrats dar. Dadurch ist es möglich, die Auswirkung von Prozesstreuungen auf die Transistor-Schaltgeschwindigkeit direkt auf dem Chip zu erfassen und bei der Takterzeugung zu berücksichtigen. Zur Ermittlung der Schaltgeschwindigkeit der Transistoren kann anstelle des XOR-Gatters auch ein XNOR-Gatter verwendet werden.

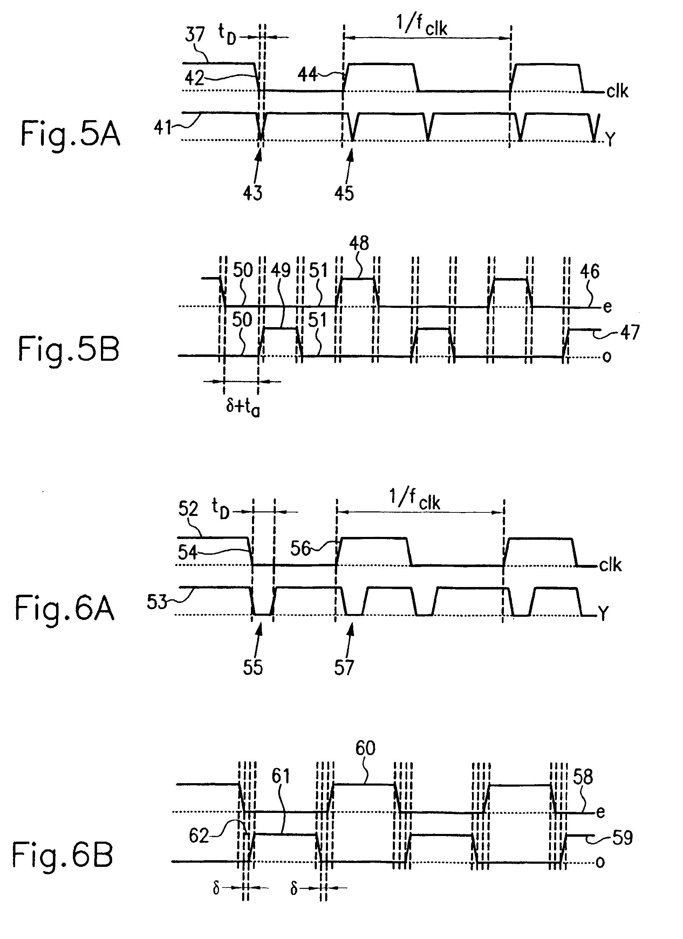

In Fig. 5A sind das Eingangstaktsignal 37 sowie das Ausgangssignal 41 des XOR-Gatters 40 in ihrem zeitlichen Verlauf dargestellt. Beim Übergang des Eingangstaktsignals 37 von 1 auf 0 ergibt sich eine abfallende Signalflanke 42, die im Ausgangssignal 41 einen Puls 43 der Pulsweite $t_D$ auslöst. Während der Pulsdauer $t_D$ nimmt das Ausgangssignal 41 den Wert 0 an.

Beim Übergang des Eingangstaktsignals 37 von 0 auf 1 ergibt sich eine ansteigende Signalflanke 44, die ebenfalls einen Puls 45 der Länge $t_D$ auslöst. Die in Fig. 5A gezeigten Pulse 43, 45 sind kurz, die entsprechenden Werte von $t_D$ sind niedrig. Dies bedeutet, daß die Inverter 38 nur eine geringe Signalverzögerung bewirken, und dies läßt auf eine hohe Schaltgeschwindigkeit der Transistoren sowie auf eine kurze Einschwingzeit der Operationsverstärker schließen.

Das Pulssignal 41 wird dem programmierbaren Taktgenerator zugeführt, der die Dauer der Pulse 43, 45 digitalisiert und für die Berechnung des Schalttaktschemas heranzieht. Für den in Figur 5A dargestellten Fall kurzer Pulsdauer $t_D$ sind in Fig. 5B die vom programmierbaren Taktgenerator erzeugten Schalttaktsignale, das Even-Schalttaktsignal 46 und das Odd-Schalttaktsignal 47, dargestellt. Wegen des schnellen Einschwingverhaltens der Operationsverstärker sind nur kurze Einschaltphasen 48, 49 erforderlich.

Dementsprechend können die Schalttaktphasen 50, 51, in denen sich beide Schalttaktsignale 46 und 47 in der Aus-Phase befinden, verlängert werden. Bei dem in Fig. 2B gezeigten Taktschema des Stands der Technik hatten die gemeinsame Aus-Phasen die Zeitdauer δ. Bei dem in Fig. 5B gezeigten Taktschema ist die Dauer der gemeinsamen Aus-Phasen auf δ + $t_a$ erhöht. Die Operationsverstärker werden nur solange eingeschaltet, bis der Einschwingvorgang abgeschlossen ist. Während der gemeinsamen Aus-Phasen sind sämtliche Operationsverstärker inaktiv.

In Figur 6A sind das Eingangstaktsignal 52 sowie das Ausgangssignal 53 des XOR-Gatters 40 für den Fall langsam schaltender Transistoren bzw. langer Gatterlaufzeiten dargestellt. Die abfallende Signalflanke 54 verursacht im Ausgangssignal 53 einen Puls 55 der Dauer $t_D$, und entsprechend verursacht die ansteigende Signalflanke 56 einen Puls 57 der Dauer $t_D$. Bei dem in Fig.

6A dargestellten Beispiel weisen die Transistoren nur geringe Schaltgeschwindigkeit auf. Die Inverter 38 verzögern das Signal daher erheblich, und dies führt zu einer langen Pulsdauer $t_D$. Daraus kann auf ein langsames Einschwingverhalten der Operationsverstärker geschlossen werden.

In Fig. 6B sind die zugehörigen Schalttaktsignale, das Even-Schalttaktsignal 58 sowie das Odd-Schalttaktsignal 59, in ihrem zeitlichen Verlauf dargestellt. Wegen des langsamen Einschwingverhaltens der Operationsverstärker müssen die Einschaltphasen 60, 61 der beiden Schalttaktsignale lang gewählt werden. Dementsprechend muß die gemeinsame Aus-Phase 62 der Schalttaktsignale auf die minimale Dauer δ herabgesetzt werden. Dies bedeutet, daß $t_a$ = 0 gesetzt wird.

Der programmierbare Taktgenerator bildet die Pulsdauer $t_D$ auf die Dauer der gemeinsamen Aus-Phase δ + $t_a$ ab, wobei ein kleiner Wert von $t_D$ auf einen großen Wert von δ + $t_a$ abgebildet wird, und wobei ein großer Wert von $t_D$ auf einen kleinen Wert von $t_a$ abgebildet wird. Auf diese Weise kann das Schalttaktschema so an die Schaltgeschwindigkeit der Transistoren angepaßt werden, daß die Leistungseinsparung maximal ist.

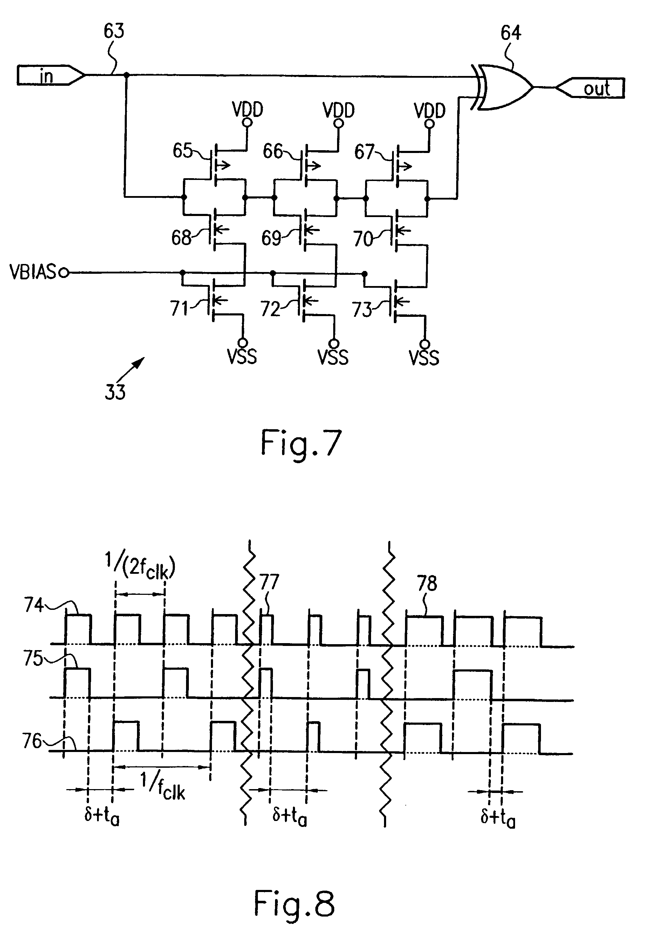

In Fig. 7 ist eine Ausführungsform der Schaltung 33 zur Bestimmung der Transistor-Schaltgeschwindigkeit gezeigt, welche selektiv das Schaltverhalten von n-MOSFETs erfaßt. Die Verwendung einer derartigen Schaltung empfiehlt sich dann, wenn das Einschwingverhalten der verwendeten Operationsverstärker hauptsächlich von den Eigenschaften der Transistoren vom n-Typ bestimmt wird. Die Schaltung umfaßt die p-MOSFETs 65, 66, 67 sowie die n-MOSFETs 68, 69, 70, 71, 72, 73. Der Strom durch die FETs hängt dabei vom Verhältnis von Breite zu Länge (W/L) des jeweiligen FETs ab. Bei dem in Fig. 7 gezeigten Beispiel weisen die p-FETs 65, 66, 67 sowie die n-FETs 68, 69, 70 ein großes W/L auf. Strombegrenzend wirken daher die n-FETs 71, 72, 73, deren W/L-Verhältnis wesentlich niedriger ist als das der anderen Devices.

Wenn das Eingangssignal 63 auf VSS übergeht, wird der p-FET 65 durchgeschaltet. Das Gate des n-MOSFETs 69 liegt dann auf VDD, und bei geeigneter Wahl von VBIAS ist auch der n-FET 72 leitend. Das Potential VSS kann dann zum Gate des p-Typ FET 67 durchgeschaltet werden. Durch diesen FET wird ein Eingang des XOR-Gatters 64 auf VDD gelegt. Wegen des gegenüber den W/L-Werten der FETs 65, 67, 69 geringen Werts von W/L beim n-FET 72 wird die Gesamtverzögerung im wesentlichen durch den n-FET 72 bestimmt. Bei einem Übergang des Eingangssignals 63 auf VDD dagegen hängt die Gesamtverzögerung im wesentlichen von der Schaltgeschwindiget der n-FETs 71 und 73 ab. In jedem Fall wird daher die Gesamtverzögerung hauptsächlich durch die n-FETs mit kleinem W/L bestimmt.

In Fig. 8 ist eine Methode gezeigt, wie das erfindungsgemäße Taktschema extern mittels eines Rechteckgenerators und einer Teilerschaltung erzeugt werden kann. Der Rechteckgenerator liefert ein Rechtecksignal 74 der Frequenz ($2 \cdot f_{clk}$). Aus diesem Rechtecksignal 74 wird mittels einer Teilerschaltung das Even-Schalttaktsignal 75 sowie das Odd-Schalttaktsignal 76 abgeleitet, welche jeweils die Periodizität $\dfrac{1}{f_{clk}}$ aufweisen.

Die Dauer der gemeinsamen Aus-Phase, in der beide Schalttaktsignale gleich 0 sind, kann dabei durch Variation des Tastverhältnisses des Rechtecksignals eingestellt werden. Das Tastverhältnis des Rechtecksignals 74 beträgt 1/2, während das Tastverhältnis des Rechtecksignals 77 1/4 beträgt. Das Rechtecksignal 78 weist ein Tastverhältnis von 3/4 auf. Aus dem in Fig. 8 dargestellten Taktschemas sind die zu den einzelnen Tastverhältnissen gehörigen Werte von $\delta + t_a$ erkennbar. Je größer das Tastverhältnis gewählt wird, desto kürzer wird die Dauer der gemeinsamen Aus-Phase $\delta + t_a$. Umgekehrt bewirkt ein kleines Tastverhältnis eine deutliche Verlängerung der gemeinsamen Aus-Phase. Mittels der in Fig. 8 gezeigten externen Schaltung kann herausgefunden werden, wie groß die Streuung des Einschwingverhaltens bei einer bestimmten Switched-Opamp-Schaltung ist und ob noch Potential zur Leistungseinsparung vorhanden ist.

**Patentansprüche**

1. Schaltungsanordnung in Switched-Opamp-Technik, welche aufweist

  - mindestens einen schaltbaren Operationsverstärker (1);
  - mindestens einen mit dem Eingang des Operationsverstärkers verbindbaren Sampling-Kondensator (2);
  - mindestens einen Integrationskondensator (3);
  - Mittel zur Takterzeugung, welche mindestens zwei nichtüberlappende Schalttaktsignale (46, 47) erzeugen,
  - wobei das eine der beiden Schalttaktsignale (46) die Aufladung des Sampling-Kondensators (2) steuert,
  - wobei das andere der beiden Schalttaktsignale (47) den Operationsverstärker (1) ein- und ausschaltet,

  **gekennzeichnet durch**
  Mittel zur Variation der Schalttaktphasen (50, 51), in denen sich sämtliche Schalttaktsignale (46, 47) in der Aus-Phase befinden.

2. Schaltungsanordnung nach Anspruch 1,
  **dadurch gekennzeichnet, daß**
  jede der Schalttaktphasen (50, 51), in denen sich sämtliche Schalttaktsignale (46, 47) in der Aus-Phase befinden, variierbar ist.

3. Schaltungsanordnung nach Anspruch 1,
  **dadurch gekennzeichnet, daß**
  jede zweite der Schalttaktphasen (51), in denen sich sämtliche Schalttaktsignale (46, 47) in der Aus-Phase befinden, variierbar ist.

4. Schaltungsanordnung nach einem der vorhergehenden Ansprüche,
  **dadurch gekennzeichnet, daß**
  die Dauer der Schalttaktphasen (50, 51), in denen sich sämtliche Schalttaktsignale (46, 47) in der Aus-Phase befinden, in Abhängigkeit vom Einschwingverhalten des Operationsverstärkers (1) variierbar ist.

5. Schaltungsanordnung nach einem der vorhergehenden Ansprüche,
  **dadurch gekennzeichnet, daß**
  die Dauer der Schalttaktphasen (50, 51), in denen sich sämtliche Schalttaktsignale (46, 47) in der Aus-Phase befinden, in Abhängigkeit von der Schaltgeschwindigkeit der Transistoren variierbar ist.

6. Schaltungsanordnung nach einem der vorhergehenden Ansprüche,
  **dadurch gekennzeichnet, daß**
  die Schaltungsanordnung Mittel (33) zur Erfassung der Transistor-Schaltgeschwindigkeit umfaßt

7. Schaltungsanordnung nach Anspruch 6,
  **dadurch gekennzeichnet, daß**
  die Schaltgeschwindigkeit von n-Kanal FETs (71, 72, 73) und/oder von p-Kanal FETs separat erfaßbar ist.

8. Schaltungsanordnung nach einem der Ansprüche 6 oder 7,
  **dadurch gekennzeichnet, daß**
  die Mittel (33) zur Erfassung der Transistor-Schaltgeschwindigkeit ein XOR-Gatter (40) oder ein XNOR-Gatter umfassen, an dessen Eingängen ein nicht verzögertes Flankensignal (37) sowie ein über eine Inverterkette (38) verzögertes Flankensignal (39) anlegbar sind.

9. Schaltungsanordnung nach einem der Ansprüche 6 bis 8,
  **dadurch gekennzeichnet, daß**
  die Mittel (33) zur Erfassung der Transistor-Schaltgeschwindigkeit Pulse (43, 45) erzeugen, deren Dauer die Schaltgeschwindigkeit der Transistoren charakterisiert.

10. Schaltungsanordnung nach Anspruch 9,
  **dadurch gekennzeichnet, daß**

die Dauer der Schalttaktphasen (50, 51), in denen sich sämtliche Schalttaktsignale (46, 47) in der Aus-Phase befinden, in Abhängigkeit von der Dauer der Pulse (43, 45) einstellbar ist.

11. Schaltungsanordnung nach einem der vorhergehenden Ansprüche
**dadurch gekennzeichnet, daß**
die Dauer der Schalttaktphasen (50, 51), in denen sich sämtliche Schalttaktsignale (46, 47) in der Aus-Phase befinden, in mehreren vorgegebenen Stufen einstellbar ist.

12. Schaltungsanordnung nach einem der vorhergehenden Ansprüche,
**dadurch gekennzeichnet, daß**
die Mittel zur Takterzeugung sowie die Mittel zur Variation der Schalttaktphasen, in denen sich sämtliche Schalttaktsignale (46, 47) in der Aus-Phase befinden, mittels eines programmierbaren Taktgenerators (31) realisiert sind.

13. Schaltungsanordnung nach einem der Ansprüche 1 bis 11
**dadurch gekennzeichnet, daß**
die Mittel zur Takterzeugung sowie die Mittel zur Variation der Schalttaktphasen, in denen sich sämtliche Schalttaktsignale (46, 47) in der Aus-Phase befinden, mittels eines externen Rechteckgenerators und einer Teilerschaltung realisiert sind, welche aus einem Rechtecksignal (74) die mindestens zwei Schalttaktsignale (75, 76) erzeugt.

14. Schaltungsanordnung nach Anspruch 13,
**dadurch gekennzeichnet, daß**
die Variation der Schalttaktphasen, in denen sich sämtliche Schalttaktsignale in der Aus-Phase befinden, durch Einstellen des Tastverhältnisses des Rechtecksignals (74, 77, 78) erfolgt.

15. Schaltungsanordnung nach einem der vorhergehenden Ansprüche,
**dadurch gekennzeichnet, daß**
die Schaltungsanordnung in volldifferentieller Schaltungstechnik realisiert ist.

16. Verfahren zur Taktung aufeinanderfolgender in Switched-Opamp-Technik ausgeführter Operationsverstärker-Stufen,
**gekennzeichnet durch** folgende Schritte:

a) Erzeugen von mindestens zwei nichtüberlappenden Schalttaktsignalen (46, 47), wobei das erste Schalttaktsignal (47) einen ersten Operationsverstärker (1) ein- und ausschaltet, und wobei das zweite Schalttaktsignal (46) einen zweiten Operationsverstärker (2) ein- und ausschaltet;
b) Variieren der Schalttaktphasen (50, 51), in denen sämtliche Operationsverstärker (1, 2) ausgeschaltet sind.

17. Verfahren nach Anspruch 16,
**dadurch gekennzeichnet, daß**
jede der Schalttaktphasen (50, 51), in denen sämtliche Operationsverstärker (1, 2) ausgeschaltet sind, variiert wird.

18. Verfahren nach Anspruch 16,
**dadurch gekennzeichnet, daß**
jede zweite der Schalttaktphasen (51), in denen sämtliche Operationsverstärker (1, 2) ausgeschaltet sind, variiert wird.

19. Verfahren nach einem der Ansprüche 16 bis 18,
**dadurch gekennzeichnet, daß**
die Dauer der Schalttaktphasen (50, 51), in denen sämtliche Operationsverstärker (1, 2) ausgeschaltet sind, in Abhängigkeit vom Einschwingverhalten der Operationsverstärker (1, 2) variiert wird.

20. Verfahren nach einem der Ansprüche 16 bis 19,
**dadurch gekennzeichnet, daß**
die Dauer der Schalttaktphasen (50, 51), in denen sämtliche Operationsverstärker (1, 2) ausgeschaltet sind, in Abhängigkeit von der Schaltgeschwindigkeit der Transistoren variiert wird.

21. Verfahren nach einem der Ansprüche 16 bis 20,
**dadurch gekennzeichnet, daß**
die Schaltgeschwindigkeit von n-Kanal FETs (71, 72, 73) und/oder von p-Kanal FETs separat erfaßt wird.

22. Verfahren nach einem der Ansprüche 16 bis 21,
**dadurch gekennzeichnet, daß**
die Dauer der Schalttaktphasen (50, 51), in denen sämtliche Operationsverstärker (1, 2) ausgeschaltet sind, in mehreren vorgegebenen Stufen einstellbar ist.

23. Verfahren nach einem der Ansprüche 16 bis 22,
**dadurch gekennzeichnet, daß**
die mindestens zwei nichtüberlappenden Schalttaktsignale (46, 47) mittels eines programmierbaren Taktgenerators (31) erzeugt werden.

24. Verfahren nach einem der Ansprüche 16 bis 22,
**dadurch gekennzeichnet, daß**
die mindestens zwei nichtüberlappenden Schalttaktsignale (75, 76) mittels eines externen Rechteckgenerators und einer Teilerschaltung erzeugt werden.

25. Verfahren nach Anspruch 24,
**dadurch gekennzeichnet, daß**

die Variation der Schalttaktphasen, in denen sämtliche Operationsverstärker (1, 2) ausgeschaltet sind, durch Einstellen des Tastverhältnisses des Rechtecksignals (74, 77, 78) erfolgt.

## Claims

1. Circuit arrangement in switched op-amp technology which exhibits the following:

    - at least one switchable operational amplifier (1);
    - at least one sampling capacitor (2) which can be connected to the input of the operational amplifier;
    - at least one integration capacitor (3);
    - means for clock generation which generate at least two non-overlapping switching-clock signals (46, 47),
    - one of the two switching-clock signals (46) controlling the charging of the sampling capacitor (2),
    - the other one of the two switching-clock signals (47) switching the operational amplifier (1) on and off,

    **characterized by**
    means for varying the switching-clock phases (50, 51) in which all switching-clock signals (46, 47) are in the off-phase.

2. Circuit arrangement as claimed in claim 1,
    **characterized in that**
    each of the switching-clock phases (50, 51) in which all switching-clock signals (46, 47) are in the off-phase can be varied.

3. Circuit arrangement as claimed in claim 1,
    **characterized in that**
    each second one of the switching-clock phases (51), in which all switching-clock signals (46, 47) are in the off-phase, can be varied.

4. Circuit arrangement as claimed in one of the preceding claims,
    **characterized in that**
    the duration of the switching-clock phases (50, 51) in which all switching-clock signals (46, 47) are in the off-phase can be varied in dependence on the transient response of the operational amplifier (1).

5. Circuit arrangement as claimed in one of the preceding claims,
    **characterized in that**
    the duration of the witching-clock phases (50, 51) in which all switching-clock signals (46, 47) are in the off-phase can be varied in dependence on the switching speed of the transistors.

6. Circuit arrangement as claimed in one of the preceding claims,
    **characterized in that**
    the circuit arrangement comprises means (33) for detecting the transistor switching speed.

7. Circuit arrangement as claimed in claim 6,
    **characterized in that**
    the switching speed of n-channel FETs (71, 72, 73) and/or of p-channel FETs can be detected separately.

8. Circuit arrangement as claimed in one of claims 6 or 7,
    **characterized in that**
    the means (33) for detecting the transistor switching speed comprise an XOR gate (40) or an XNOR gate, to the inputs of which an undelayed edge signal (37) and an edge signal (39) delayed via an inverter chain (38) can be applied.

9. Circuit arrangement as claimed in one of claims 6 to 8,
    **characterized in that**
    the means (33) for detecting the transistor switching speed generate pulses (43, 45), the duration of which characterizes the switching speed of the transistors.

10. Circuit arrangement as claimed in claim 9,
    **characterized in that**
    the duration of the switching-clock phases (50, 51) in which all switching-clock signals (46, 47) are in the off-phase can be adjusted in dependence on the duration of the pulses (43, 45).

11. Circuit arrangement as claimed in one of the preceding claims,
    **characterized in that**
    the duration of the switching-clock phases (50, 51) in which all switching-clock signals (46, 47) are in the off-phase can be adjusted in a number of predetermined steps.

12. Circuit arrangement as claimed in one of the preceding claims,
    **characterized in that**
    the means for clock generation and the means for varying the switching-clock phases in which all switching-clock signals (46, 47) are in the off-phase are implemented by means of a programmable clock generator (31).

13. Circuit arrangement as claimed in one of claims 1 to 11,
    **characterized in that**
    the means for clock generation and the means for varying the switching-clock phases in which all switching-clock signals (46, 47) are in the off-phase are implemented by means of an external squarewave generator and a divider circuit which generates the at least two switching-clock signals (75, 76) from a squarewave signal (74).

14. Circuit arrangement as claimed in claim 13, **characterized in that** the switching-clock phases in which all switching-clock signals are in the off-phase are varied by adjusting the duty ratio of the squarewave signal (74, 77, 78).

15. Circuit arrangement as claimed in one of the preceding claims, **characterized in that** the circuit arrangement is implemented in fully differential circuit technology.

16. Method for clocking successive operational amplifier stages constructed in switched op-amp technology, **characterized by** the following steps:

    a) generating at least two non-overlapping switching-clock signals (46, 47), the first switching-clock signal (47) switching a first operational amplifier (1) on and off, and the second switching-clock signal (46) switching a second operational amplifier (2) on and off;
    b) varying the switching-clock phases (50, 51) in which all operational amplifiers (1, 2) are switched off.

17. Method as claimed in claim 16, **characterized in that** each of the switching-clock phases (50, 51) in which all operational amplifiers (1, 2) are switched off is varied.

18. Method as claimed in claim 16, **characterized in that** each second one of the switching-clock phases (51) in which all operational amplifiers (1, 2) are switched off is varied.

19. Method as claimed in one of claims 16 to 18, **characterized in that** the duration of the switching-clock phases (50, 51) in which all operational amplifiers (1, 2) are switched off are varied in dependence on the transient response of the operational amplifiers (1, 2).

20. Method as claimed in one of claims 16 to 19, **characterized in that** the duration of the switching-clock phases (50, 51) in which all operational amplifiers (1, 2) are switched off is varied in dependence on the switching speed of the transistors.

21. Method as claimed in one of claims 16 to 20, **characterized in that** the switching speed of n-channel FETs (71, 72, 73) and/or of p-channel FETs is detected separately.

22. Method as claimed in one of claims 16 to 21, **characterized in that** the duration of the switching-clock phases (50, 51) in which all operational amplifiers (1, 2) are switched off can be adjusted in a number of predetermined steps.

23. Method as claimed in one of claims 16 to 22, **characterized in that** the at least two non-overlapping switching-clock signals (46, 47) are generated by means of a programmable clock generator (31).

24. Method as claimed in one of claims 16 to 22, **characterized in that** the at least two non-overlapping switching-clock signals (75, 76) are generated by means of an external squarewave generator and a divider circuit.

25. Method as claimed in claim 24, **characterized in that** the switching-clock phases in which all operational amplifiers (1, 2) are switched off are varied by adjusting the duty ratio of the squarewave signal (74, 77, 78).

**Revendications**

1. Circuit dans la technique des amplificateurs opérationnels commutés, qui comprend :

    - au moins un amplificateur (1) opérationnel commutable ;
    - au moins un condensateur (2) sampling pouvant être relié à l'entrée de l'amplificateur opérationnel ;
    - au moins un condensateur (3) d'intégration ;
    - des moyens de production de cadencement, qui produisent au moins deux signaux (46, 47) de cadencement de commutation qui ne se chevauchent pas ;
    - dans lequel l'un des deux signaux (46) de cadencement de commutation commande la charge du condensateur (2) sampling ;
    - dans lequel l'autre des deux signaux (47) de cadencement de commutation met en circuit et hors circuit l'amplificateur 1 opérationnel,

    **caractérisé par** des moyens pour faire varier les phases (50, 51) de cadencement de commutation, dans lesquelles l'ensemble des signaux (46, 47) de cadencement de commutation se trouve dans la phase arrêt.

2.  Circuit suivant la revendication 1,
    **caractérisé en ce que**
    chacune des phases (50, 51) de cadencement de commutation, dans lesquelles l'ensemble des signaux (46, 47) de cadencement de commutation se trouvant dans la phase arrêt, est variable.

3.  Circuit suivant la revendication 1,
    **caractérisé en ce que**
    une sur deux des phases (51) de cadencement de commutation dans lesquelles la somme des signaux (46, 47) de cadencement de commutation se trouve dans la phase arrêt, est variable.

4.  Circuit suivant l'une des revendications précédents,
    **caractérisé en ce que**
    la durée des phases (50, 51) de cadencement de commutation dans lesquelles l'ensemble des signaux (46, 47) de cadencement de commutation se trouve dans la phase arrêt est variable en fonction du comportement en régime transitoire de l'amplificateur (1) opérationnel.

5.  Circuit suivant l'une des revendications précédents,
    **caractérisé en ce que**
    la durée des phases (50, 51) de cadencement de commutation, dans lesquelles l'ensemble des signaux (46, 47) de cadencement de commutation se trouve dans la phase arrêt, est variable en fonction de la vitesse de commutation des transistors.

6.  Circuit suivant l'une des revendications précédents,
    **caractérisé en ce que**
    le circuit comprend des moyens (33) de détection de la vitesse de commutation de transistor.

7.  Circuit suivant la revendication 6,
    **caractérisé en ce que**
    la vitesse de commutation de FET (71, 72, 73) à canal n et/ou de FET à canal p peut être détectée séparément.

8.  Circuit suivant l'une des revendications 6 ou 7,
    **caractérisé en ce que**
    les moyens (33) de détection de la vitesse de commutation de transistor comprennent une porte (40) OU exclusif ou une porte NON-OU exclusif aux entrées desquelles peuvent être appliqués un signal (37) de front non retardé ainsi qu'un signal (39) de front retardé par une chaîne (38) inverseuse.

9.  Circuit suivant l'une des revendications 6 à 8,
    **caractérisé en ce que**
    les moyens (33) de détection de la vitesse de commutation des transistors produisent des impulsions (43, 45) dont la durée caractérise la vitesse de commutation des transistors.

10. Circuit suivant la revendication 9,
    **caractérisé en ce que**
    la durée des phases (50, 51) de cadencement de commutation, dans lesquelles l'ensemble des signaux (46, 47) de cadencement de commutation se trouve dans la phase arrêt, peut être réglée en fonction de la durée des impulsions (43, 45).

11. Circuit suivant l'une des revendications précédentes,
    **caractérisé en ce que**
    la durée des phases (50, 51) de cadencement de commutation, dans lesquelles l'ensemble des signaux (46, 47) de cadencement de commutation se trouve dans la phase arrêt, peut être réglée en plusieurs paliers prescrits.

12. Circuit suivant l'une des revendications précédentes,
    **caractérisé en ce que**
    les moyens de production de cadencement ainsi que les moyens pour faire varier les phases de cadencement de commutation, dans lesquelles l'ensemble des signaux (46, 47) de cadencement de commutation se trouve à la phase arrêt, sont réalisés au moyen d'un générateur (31) de cadencement qui peut être programmé.

13. Circuit suivant l'une des revendications 1 à 11,
    **caractérisé en ce que**
    les moyens de production de cadencement ainsi que les moyens pour faire varier les phases de cadencement de commutation, dans lesquelles l'ensemble des signaux (46, 47) de cadencement de commutation se trouve à la phase arrêt, sont réalisés au moyen d'un générateur extérieur de signal rectangulaire et d'un circuit diviseur qui produit les au moins deux signaux (75, 76) de cadencement de commutation à partir d'un signal (74) rectangulaire.

14. Circuit suivant la revendication 13,
    **caractérisé en ce que**
    les variations des phases de cadencement de commutation, dans lesquelles l'ensemble des signaux de cadencement de commutation se trouve dans la phase arrêt, s'effectuent en réglant le rapport de cycle du signal (74, 77, 78) rectangulaire.

15. Circuit suivant l'une des revendications précédentes,
    **caractérisé en ce que**
    le montage est réalisé en technique de circuit entièrement différentielle.

**16.** Procédé de cadencement d'étages d'amplificateurs opérationnels réalisés en technique d'amplificateurs opérationnels commutés,
**caractérisé par** les stades suivants :

a) on produit au moins deux signaux (46, 47) de cadencement de commutation qui ne se chevauchent pas,
dans lequel le premier signal (47) de cadencement de commutation met en circuit et hors circuit un premier amplificateur (1) opérationnel, et dans lequel le deuxième signal (46) de cadencement de commutation met en circuit et hors circuit un deuxième amplificateur (2) opérationnel ;
b) on fait varier les phases (50, 51) de cadencement de commutation, dans lesquelles tous les amplificateurs (1, 2) opérationnels sont mis hors circuit.

**17.** Circuit suivant la revendication 16,
**caractérisé en ce que**
l'on fait varier chacune des phases (50, 51) de cadencement de commutation, dans lesquelles tous les amplificateurs (1, 2) opérationnels sont mis hors circuit.

**18.** Circuit suivant la revendication 16,
**caractérisé en ce que**
l'on fait varier une phase (51) de cadencement de commutation sur deux, dans lesquelles tous les amplificateurs (1, 2) sont mis hors circuit.

**19.** Circuit suivant l'une des revendications 16 à 18,
**caractérisé en ce que**
l'on fait varier la durée des phases (50, 51) de cadencement de commutation, dans lesquelles tous les amplificateurs (1, 2) opérationnels sont mis hors circuit, en fonction du comportement en régime transitoire des amplificateurs (1, 2) opérationnels.

**20.** Circuit suivant l'une des revendications 16 à 19,
**caractérisé en ce que**
l'on fait varier la durée des phases (50, 51) de cadencement de commutation, dans lesquelles tous les amplificateurs (1, 2) opérationnels sont mis hors circuit, en fonction de la vitesse de commutation des transistors.

**21.** Circuit suivant l'une des revendications 16 à 20,
**caractérisé en ce que**
l'on détecte séparément la vitesse de commutation, de FET (71, 72, 73) à canal n et/ou de FET à canal p.

**22.** Circuit suivant l'une des revendications 16 à 21,
**caractérisé en ce que**
l'on peut régler en plusieurs échelons prescrits la durée des phases (50, 51) de cadencement de commutation dans lesquelles tous les amplificateurs (1, 2) opérationnels sont mis hors circuit.

**23.** Circuit suivant l'une des revendications 16 à 22,
**caractérisé en ce que**
l'on produit les au moins deux signaux de (46, 47) de cadencement de commutation qui ne se chevauchent pas au moyen d'un générateur (31) de cadencement programmable.

**24.** Circuit suivant l'une des revendications 16 à 22,
**caractérisé en ce que**
l'on produit les au moins deux signaux (75, 76) de cadencement de commutation qui ne se chevauchent pas au moyen d'un générateur extérieur de signal rectangulaire et d'un circuit diviseur.

**25.** Circuit suivant la revendication 24,
**caractérisé en ce que**
l'on effectue la variation des phases de cadencement de commutation, dans lesquelles tous les amplificateurs (1, 2) opérationnels sont mis hors circuit, en réglant le rapport de cycle du signal (74, 77, 78) rectangulaire.

Fig.1

Stand der Technik

Fig.2A
Stand der Technik

Fig.2B
Stand der Technik

Fig.3

Fig.4

Fig.5A

$t_D$   $1/f_{clk}$

clk

Y

43   45

Fig.5B

$50$   $49$   $51$   $48$   $46$

$50$   $51$   $47$

e

o

$\delta + t_a$

Fig.6A

$t_D$   $1/f_{clk}$

clk

Y

55   57

Fig.6B

$61$   $60$   $58$

$62$   $59$

e

o

$\delta$   $\delta$

Fig.7

Fig.8